Europäisches Patentamt

European Patent Office

Office européen des brevets

(11) Publication number: 0 381 253
A1

## (12) EUROPEAN PATENT APPLICATION

(21) Application number: 90200003.3

(22) Date of filing: 02.01.90

(51) Int. Cl.⁵: **C30B 33/00, H01L 21/00**

(30) Priority: 02.01.89 NL 8900003

(43) Date of publication of application:
08.08.90 Bulletin 90/32

(84) Designated Contracting States:
AT BE CH DE DK ES FR GB GR IT LI LU NL SE

(71) Applicant: INTERUNIVERSITAIR
MICROELEKTRONICA CENTRUM VZW
Kapeldreef 75
B-3030 Leuven-Heverlee(BE)

(72) Inventor: Vandenabeele, Peter Michel Noel
Voordelaan 20
B-3030 Leuven(BE)
Inventor: Maex, Karen Irma Jozef
Wijgmaalsesteenweg 136
B-3020 Herent(BE)

(74) Representative: Land, Addick Adrianus
Gosling et al
OCTROOIBUREAU ARNOLD & SIEDSMA
Sweelinckplein 1
NL-2517 GK Den Haag(NL)

(54) **Apparatus and method for processing one or more wafers of material.**

(57) In this apparatus and method for processing one or more wafers a more accurate measurement of temperature of a patterned wafer is possible, as the temperature distribution is more uniform throughout the wafer.

FIG.2

EP 0 381 253 A1

# APPARATUS AND METHOD FOR PROCESSING ONE OR MORE WAFERS OF MATERIAL

## BACKGROUND OF THE INVENTION

So-called Rapid Thermal Processing (RTP) relates to heating of wafers of material, often mainly of silicon, to a temperature value of between 400 and 1400°C. for a period between 1 and 60 seconds.

A problem with existing systems for such applications is the uniformity and/or the precise determining of the temperature of a wafer. Such problems are described in the following article, which is quoted here as the state of the art:

"An Overview and Comparison of Rapid Thermal Processing Equipment: A User's Viewpoint" by S.R. Wilson, R.B.Gregory and W.M.Paulson in The Proceedings in the Mat.Res.Soc.Symp., Vol.52 (1986),

in addition to the following articles, also from these Proceedings:

"The Effect of Thin Dielectric Films on the Accuracy of Pyrometric Temperature Measurement" by D.W.Pettibone, J.R. Suarez and A.Gat; and

"Temperature Measurement and Control in a Rapid Thermal Processor".

US Patents 4,680,451 (Gat e.a.) and 4,649,261 (Sheets), and WO 87/05054.

After the first filing date of the Dutch parent case the article 'Impact of patterned layers on temperature non-uniformity during rapid thermal processing for VLSI applications' was presented in San Diego at the 1989 Spring Meeting of the Materials Research Society (April 25-28), the content of which is included here.

## SUMMARY OF THE INVENTION

The present invention provides a method and apparatus as claimed in claim 1,2 resp..

A wafer for processing in such an apparatus will have a more uniform temperature; a temperature measurement of the wafer is possible that is more accurate than according to the state of the art.

Further preferred embodiments of the present invention are described in the sub-claims.

## BRIEF DESCRIPTION OF THE DRAWING

An embodiment of a device according to the present invention will be described with reference to a drawing in which show:

Fig 1 a perpective view partly broken away and partly in section, of a first preferred embodiment of an apparatus according to the present invention for carrying out a method according to the present invention; and

Fig 2 a sectional view of a second embodiment of the method and apparatus according to the present invention.

## DETAILED DESCRIPTION OF THE DRAWING

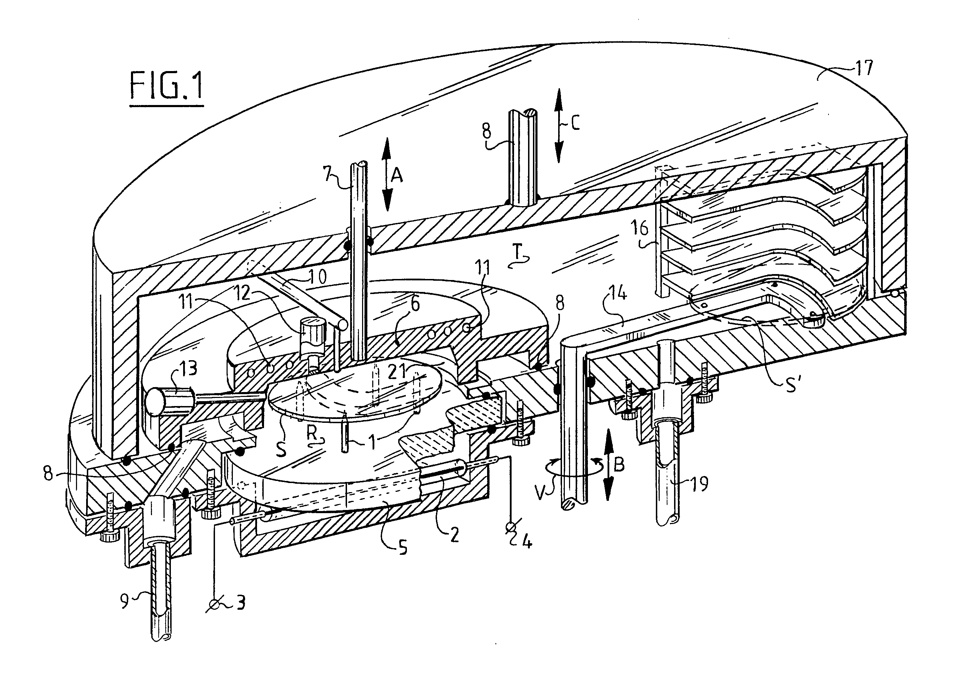

A wafer of material S (fig 1) is placed in a manner to be described later onto pins 1 of quartz material. A source 2 of heat radiation, for instance consisting of one or more quartz lamps, provided with electrical connections 3, 4 and arranged under a quartz plate 5, heats the surface of the wafer S which is not visible in the figure. The patterned side of the wafer is directed to a wall portion 6.

The wall portion 6 of the space R is up and downwardly movable (arrow A) by means of a drive rod 7. The space R thus closable via sealing 8 can be brought via connection 9 to underpressure using a pump (not shown). In addition a gas which is to be added for a particular process can if desired be introduced into the space R via the connection 10. The wall portion 6 can be cooled by means of cooling channels 11 arranged therein.

Arranged in the wall portion 6 are two radiation meters or pyrometers 12 and 13, both of which can carry out a temperature measurement of the wafer as they are sensitive to radiation in the infra-red range, for instance around and/or between 2 $\mu$m and 5 $\mu$m, which wave-lengths are not or hardly radiated by the quartz lamps 2. The pyrometer 13 stands disposed at a relatively small angle, for instance at an angle of about 6°, relative to the wafer S.

The pyrometer 12 is preferably sensitive in a wave-length range between 1.5 and 3.5 $\mu$m, and preferably around 2 $\mu$m, while the pyrometer 13 is preferably sensitive to radiation around 5 $\mu$m.

A carrying arm 14, which is rotatable (arrow V) and up and downwardly movable (arrow B), can, when the drive rod 7 is actuated, move wafers of material S to and from the space R to and from a cassette 16, over which is arranged a second wall portion or bell-shaped portion 17 provided with a pulling rod 18. The space T thus formed can be opened and closed by up and downward movement (arrow C) and can be brought via connection 19 to underpressure using a pump (not shown).

The wall 21 facing the wafer of material S is situated on the side of the wafer turned away from the quartz lamp 2 so that the temperature measured by means of the pyrometer 12, 13 provides a measured value which, also because of the uniformity, represents a more correct value than the temperature radiation radiating from the other side of the wafer. For this purpose the wall 21 preferably takes a reflecting form. In this way variations in the emissivity of different parts of the wafer are compensated.

The reflective wall 21 can be formed in a simple manner from a layer of aluminium arranged on stainless steel. To prevent dirtying, a layer of $SiO_2$ can be applied over the aluminium.

In the embodiment shown both pyrometers are directed toward the central portion of the wafer of material that is to be carried in. The radiation coming from this central portion is reflected back to this central portion because of the shape of the wall 21. In the embodiment shown the upper side of the wafer of material S will often be provided with a pattern of integrated structures which, depending on the material, such as metals (titanium, aluminium) or $SiO_2$, can have a somewhat mutually differing reflection coefficient. Computations can be made as a result of the reflections against the wall 21, to determine the temperature of the wafer, with a practically uniform reflection coefficient over the wafer of material, which is for instance 0.5 mm thick.

As a result of the reflecting wall 21 the pyrometer 13 standing at a relatively small angle suffers no hindrance from this disposition at a small angle.

The form of the wall 21 is preferably close fitting around the wafers of material for carrying in.

The embodiment shown, wherein wafers of material are taken from a vacuum space T to a vacuum space R, provides the advantage that the high vacuum to be reached in the space R can be achieved rapidly.

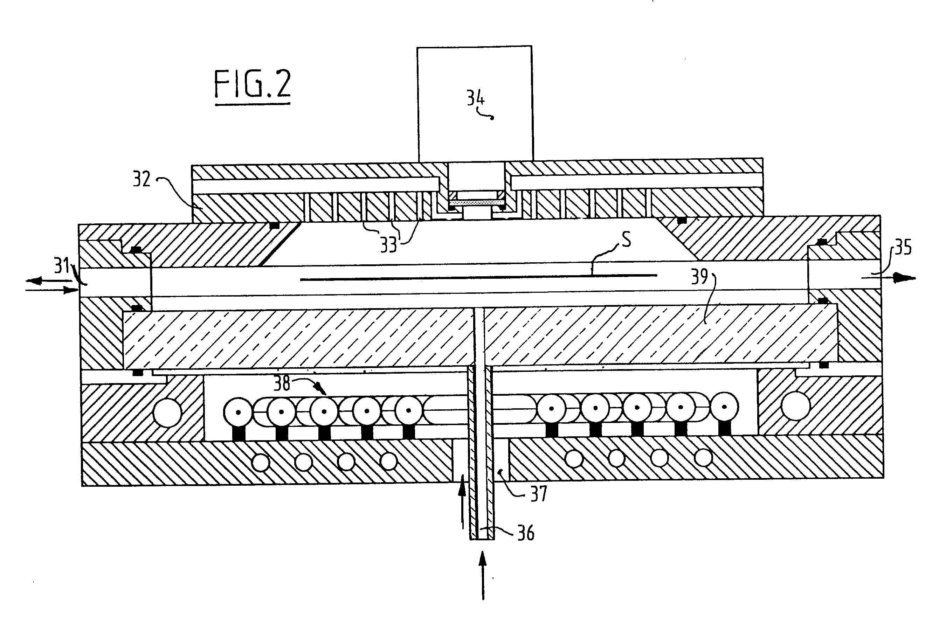

In the second embodiment (fig 2) a wafer is transported through an input/output gate 31 having its patterned side faced to a reflecting wall 32 in which channels 33 for reactive gas are provided. A pyrometer 34 senses the temperature of the wafer S′. Gas is sucked out through gas output 35. Purge gas is entered through line 36 and cooling gas through input line 37. Tungsten halogen lamps 38 for heating the wafer S′ through quartz window 39 can be arranged in patterns different from that shown in fig 1, as known per se from the prior art.

The second embodiment includes the following advantages:
- the edge of the wafer is cooled as less as possible, as gas can flow out above the wafer;
- the wafers are to be transported into and out of the apparatus through the same gate which is to be connected to a load-lock space;
- the arrangement of the lamps will provide in uniformly heating (the underside of) the wafer;

- the purge through line 36 prevents any deposition or reaction at the underside of the wafer; and/or
- the inflow of gas through channels 32 provides in an uniform gas concentration above the wafer.

The present invention is not limited to the embodiment shown; the rights are determined by the claims following hereinafter.

## Claims

1. A method of processing one or more wafers having at least on one side a pattern of more and less conducting areas, comprising the following steps:
- transporting the wafer into a space having a reflecting wall to which the patterned side is to be turned;
- heating the wafer by means of a radiation source from the side opposite the paterned side; and
- measuring the temperature of the wafer at the patterned side and at the reflecting wall through a radiation sensitive device or pyrometer.

2. An apparatus for processing one or more wafers of material, comprising:
- a space into which the wafer of material is to be carried; and
- a radiation source for radiation directed onto a surface of the wafer to be carried in,
wherein the space is provided with a reflecting wall which extends opposite that surface of the wafer of material that is turned away from the radiation source.

3. An apparatus as claimed in claim 2, wherein the device is provided with a connection for creating underpressure in the space.

4. An apparatus as claimed in claim 2 or 3, wherein the reflecting wall is formed by stainless steel onto which is applied aluminium and optionally a layer of $SiO_2$.

5. An apparatus as claimed in claim 2, 3 or 4, wherein non-reflecting parts of the space or chamber comprise a layer of $Al_2O_3$, optionally covered with $SiO_2$.

6. An apparatus as claimed in any of the claims 2-5, wherein the reflecting wall is situated in a cavity which is slightly larger than the wafer of material.

7. An apparatus as claimed in any of the claims 2-6, wherein one or more pyrometers directed toward the wafer to be carried in are arranged through the reflecting wall.

8. An apparatus as claimed in any of the claims 2-7, wherein the space is arranged in a second space which is provided with a connection for creating underpressure in this second space.

FIG.1

FIG.2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X,D | US-A-4 649 261 (SHEETS)(10-03-1987) * Column 9, lines 22-60; column 10, lines 11-34; column 18, lines 14-35; column 19, lines 54-66; figure 2 * | 2,3,6-8 | C 30 B 33/00 H 01 L 21/00 |
| X,D | WO-A-8 705 054 (BERTIN & CIE) * Page 10, line 26 - page 11, line 7; page 13, line 27 - page 14, line 20; figure 1; page 20, lines 18-27; figure 3 * | 2,7,8 | |
| X,D | THE PROCEEDINGS IN THE MAT. RES. SOC. SYMP., vol. 52, 1986, pages 181-190, Materials Research Society; S.R. WILSON et al.: "An overview and comparison of rapid thermal processing equipment: a users viewpoint" * Page 187 * | 2-4,6-8 | |

TECHNICAL FIELDS
SEARCHED (Int. Cl.5)

C 30 B
F 27 B
F 27 D
H 01 L

The present search report has been drawn up for all claims

| Place of search | Date of completion of the search | Examiner |
|---|---|---|
| THE HAGUE | 10-04-1990 | COOK S.D. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)